# FASCICULE DE BREVET EUROPEEN

(11) **EP 0 792 096 B1**
(45) Date de publication et mention de la délivrance du brevet: **13.08.2003**
(21) Numéro de dépôt: 97400076.2
(22) Date de dépôt: 15.01.1997
(51) Int. Cl.: H05K 7/14, H01H 71/12, H02H 7/08

(54) **Relais électronique de protection multifonctions**
Elektronisches Multifunktionsschutzrelais
Electronic relay for a multifunctional protection

(30) Priorité: 26.01.1996 FR 9601117
(43) Date de publication de la demande: 27.08.1997
(73) Titulaire: Schneider Electric Industries SAS, 92500 Rueil-Malmaison (FR)
(72) Inventeur: Romillon, Jean-Marc, 78980 Longnes (FR); Jacq, Joel, 95520 Osny (FR); Boudet, Pierre, 95280 Jouy-Le-Moutier (FR)
(74) Mandataire: Saint Martin, René

(56) Documents cités:
- EP-A- 0 214 025
- WO-A-81/01092
- US-A- 4 713 718
- CONTROL ENGINEERING INTERNATIONAL, vol. 41, no. 13, 1 Décembre 1994, pages 43-45, XP000495283 BABB M: "LOW-COST MOTOR PROTECTION BECOMES REALITY IN THE 1990S"

## Description

La présente invention se rapporte à un relais électronique de protection multifonctions comportant des capteurs de courant montés en série sur des lignes d'alimentation en courant alternatif d'une charge telle qu'un moteur électrique polyphasé.

Il existe des relais électroniques de protection à microprocesseur du type de celui que décrit le brevet EP 0214025. Ce type de relais peut assurer des fonctions de détection ou protection dans les cas suivants: surcharges thermiques, dépassement de température, déséquilibre et absence de phases, inversion de phases, défaut d'isolement à la terre, surcouple-blocage, marche à vide. Des capteurs situés sur chacune des phases d'alimentation fournissent au relais des signaux représentatifs des courants de phases. A partir de ces signaux, le relais peut calculer l'échauffement des enroulements et du moteur, déceler des anomalies de phases, etc. Il est équipé de relais de sortie indépendants qui permettent d'exploiter les informations d'alarme ou de défaut. La visualisation de l'état thermique du moteur et des défauts s'effectue au moyen de voyants situés en face avant ou par un module de visualisation à distance.

Ces relais sont montés dans un boîtier banalisé nécessitant un câblage interne.

La présente invention a pour but de fournir un agencement de relais électronique évitant les câblages internes et facilitant la construction.

Conformément à l'invention, le relais est caractérisé par le fait qu'il comporte, à l'arrière de son boîtier, une carte de puissance associée aux capteurs de courant et connectée par des connecteurs à des cartes électroniques enfichables portant des bomiers latéraux qui débouchent dans des ouvertures latérales du boîtier et, à l'avant du boîtier, une carte de dialogue et communication se connectant à au moins une des cartes enfichables.

Selon une caractéristique, les cartes enfichables se montent dans le boîtier perpendiculairement à la carte de puissance, la carte de visualisation et communication se montant. perpendiculairement aux cartes enfichables et se connectant à la carte disposée au centre.

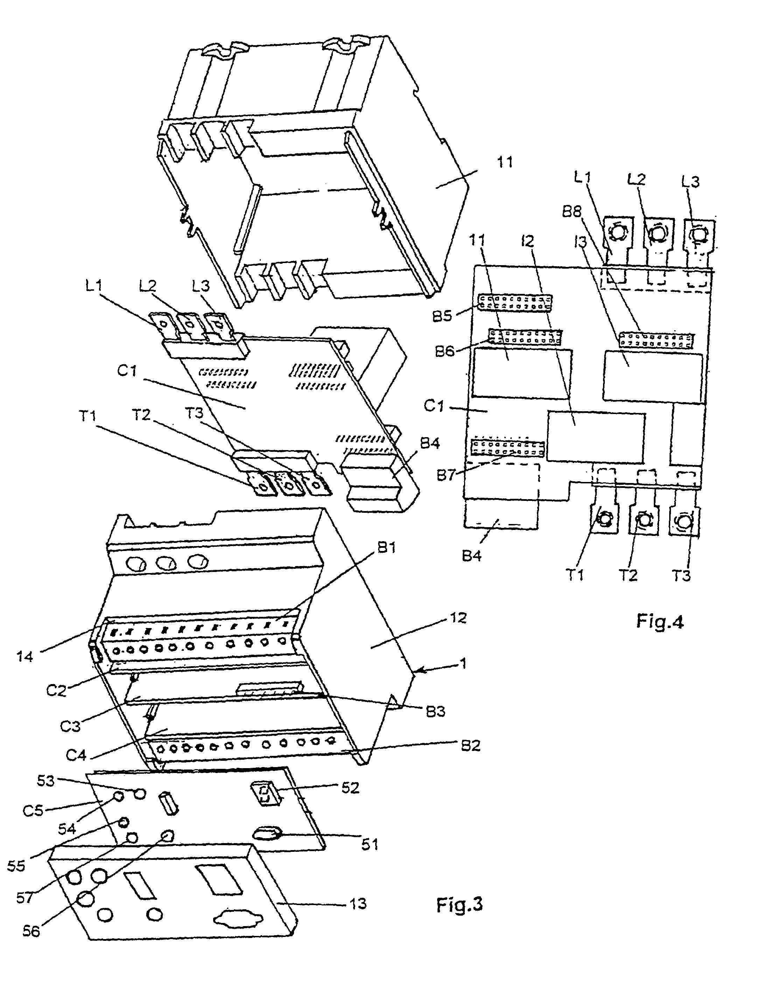

L'invention va maintenant être décrite avec plus de détail en se référant à un mode de réalisation donné à titre d'exemple et représenté par les dessins annexés sur lesquels:

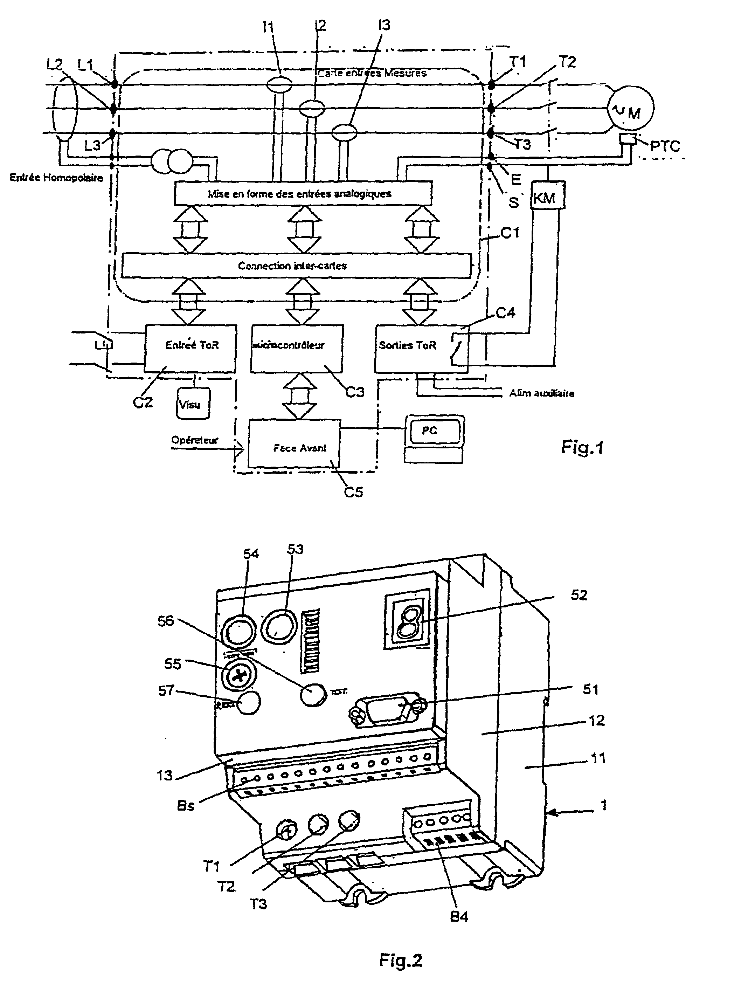

- la figure 1 est un schéma synoptique du relais électronique selon l'invention;
- la figure 2 est une vue en perpective du relais;
- ia figure 3 est une vue en perspective éclatée du relais;
- la figure 4 est une vue de l'arrière de la carte de puissance.

Le relais électronique représenté par les dessins comporte des bornes L1, L2, L3 reliées à des lignes d'alimentation en courant alternatif et des bornes T1, T2, T3 reliées à une charge, par exempte à un moteur M. Des bornes E et S peuvent être reliées à une sonde PTC du type capteur de température permettant le contrôle thermique du moteur.

Le boîtier repéré 1 dans son ensemble se compose d'un socle arrière 11 susceptible d'être fixé par l'arrière sur un support (rail par exemple), d'un coffret 12 venant se monter sur le socle 11 et d'un capot de face avant 13. Il contient une carte de puissance C1, une carte d'entrée C2, une carte de traitement C3, une carte de sortie C4 et une carte de dialogue et communication C5.

La carte de puissance C1 se loge à l'arrière, dans le socle 11 du boîtier et reçoit toutes les entrées analogiques (courants des trois phases, entrée sonde PTC, entrées d'un tore homopolaire) et rend ces entrées analogiques compatibles avec les entrées du microcontrôleur. Elle est équipée d'un bornier B4 permettant de raccorder des entrées analogiques (entrée homopolaire, sonde PTC) et elle réalise l'interconnexion avec les autres cartes du relais par l'intermédiaire de connecteurs débrochables B5, B6, B7, B8. Elle est équipée de capteurs de courant ou transformateurs I1, I2, I3 qui sont montés respectivement entre des bornes L1 et T1, L2 et T2, L3 et T3. Ces bornes se montent dans le socle 11 en face d'ouvertures permettant le passage de fils extérieurs. La carte de puissance C1 peut comporter, à côté des bornes L1, L2, L3, des bornes supplémentaires adaptés à des calibres d'intensités différents. Pour des raisons de simplicité des dessins seules les bornes L1, L2, L3 ont été représentées.

La carte d'entrée C2 se loge dans la partie supérieure du boîtier et reçoit toutes les entrées logiques et rend ces entrées logiques compatibles avec les entrées logiques du microcontrôleur. Elle est équipée, à l'arrière, d'un connecteur débrochable la connectant en B5 à la carte de puissance C1 et à l'avant d'un bornier B1 permettant d'assurer la connexion de ces entrées logiques avec l'environnement extérieur. Elle porte la connectique et l'isolement des circuits de la visualisation. Elle comporte un circuit de communication lui permettant de communiquer à distance, par l'intermédiaire du bornier B1, avec des moyens de visualisation disposés à distance de l'appareil.

La carte de traitement C3 se loge dans la partie centrale du boîtier, entre les deux autres cartes C2 et C4 et est équipée d'un microcontrôleur. Elle reçoit toutes les entrées logiques et analogiques et gère les sorties. Elle est équipée, à l'arrière, d'un connecteur débrochable la connectant en B6, B8 à la carte de puissance C1 et, à l'avant, d'un connecteur débrochable B3 assurant la connexion avec la carte de dialogue et de communication C5.

La carte d'alimentation et de sortie C4 se loge à la partie inférieure du boîtier et est équipée de relais de sortie et de l'alimentation auxiliaire. Elle est équipée, à l'arrière, d'un connecteur débrochable la connectant en B7 à la carte de puissance C1 et, à l'avant, d'un bomier B2 assurant la connexion des sorties et de l'alimentation avec l'extérieur. Elle pilote par des relais de sortie une sortie de signalisation signalant le déclenchement en cas de surcharge thermique, une sortie d'alarme signalant si l'état thermique a atteint une valeur de seuil préétablie, et des sorties de commande des moteurs qui permettent de piloter des contacteurs tels que KM1.

La carte de dialogue et de communication C5 se loge à l'avant du boîtier et est équipée des composants assurant le dialogue machine et la liaison série. Elle est connectée à la carte de traitement C3 par un connecteur débrochable 83. Elle porte un connecteur série 51 destiné à la communication avec un bus ou un ordinateur, un composant de visualisation 52 permettant d'afficher la cause d'un déclenchement, un premier organe de réglage 53 permettant de régler le courant nominal moteur, un second organe de réglage 54 permettant de régler le courant nominal moteur (la somme des réglages de 53 et 54 permettant de déterminer le courant nominal moteur), un organe 55 de réglage de la classe de déclenchement du moteur, un bouton 56 permettant un déclenchement de l'appareil (test) et un bouton de réarmement 57.

Les cartes C2, C3, C4 sont des cartes enfichables se montant dans le boîtier (dans lequel elles sont guidées par des glissières) de manière à s'étendre perpendiculairement à la carte de puissance C1. La carte de dialogue et communication C5 se monte en face avant, parallèlement à la carte de puissance C1. Les bomiers latéraux B1 et 82 s'étendent parallèlement à la face arrière du boîtier et débouchent à l'extérieur dans des ouvertures latérales 14 du boîtier. Le bornier B4 débouche également à l'extérieur par une ouverture du boîtier.

Il est bien entendu que l'on peut, sans sortir du cadre de l'invention, imaginer des variantes et des perfectionnements de détail et de même envisager l'emploi de moyens équivalents.

## Revendications

1. Relais électronique comportant des capteurs de courant (I1, I2, I3) montés, entre des bornes (L1, T1, L2, T2, L3, T3), en série sur des lignes d'alimentation en courant alternatif d'une charge (M), **caractérisé par le fait qu'**il comporte, à l'arrière de son boîtier (1), une carte de puissance (C1) associée aux capteurs de courant (I1, I2, I3) et connectée par des connecteurs à des cartes électroniques enfichables (C2, C3, C4) portant des bomiers latéraux (B1 et B2) qui débouchent dans des ouvertures latérales du boîtier et, à l'avant du boîtier, une carte de dialogue et communication (C5) se connectant à au moins une des cartes enfichables (C3).

2. Relais électronique selon la revendication 1 , **caractérisé par le fait que** les cartes enfichables (C2, C3, C4) se montent dans le boîtier perpendiculairement à la carte de puissance (C1), la carte de dialogue et communication (C5) se montant perpendiculairement aux cartes enfichables (C2, C3, C4) et se connectant à la carte disposée au centre (C3).

3. Relais électronique selon l'une quelconque des revendications précédentes, **caractérisé par le fait que** le boîtier (1) se compose d'un socle arrière (11) susceptible d'être fixé à un support, d'un coffret (12) venant se monter sur le socle (11) et d'un capot de face avant (13).

4. Relais électronique selon l'une des revendications précédentes, **caractérisé par le fait que** la première carte enfichable (C2) montée latéralement et équipée d'un bomier (B1) est une carte d'entrées logiques.

5. Relais électronique selon l'une des revendications précédentes, **caractérisé par le fait que** la seconde carte enfichable (C4) montée latéralement et équipée d'un bomier (B2) est une carte de sorties.

6. Relais électronique selon l'une des revendications précédentes, **caractérisé par le fait que** la carte enfichable (C3) montée entre les deux autres cartes (C2, C4) est la carte de traitement équipée d'un microcontrôleur.

7. Relais électronique selon l'une quelconque des revendications précédentes, **caractérisé par le fait que** la carte de dialogue et communication (C5) disposée à l'avant est connectée par un connecteur débrochable (B3) à la carte de traitement (C3) et présente un connecteur de communication (51) pour un bus ou un ordinateur.

## Patentansprüche

1. Elektronisches Relais mit Stromsensoren (I1, I2, I3), welche serienmäßig zwischen Klemmen (L1, T1, L2, T2, L3, T3) auf Wechselstrom-Netzleitungen mit einer Last (M) angebracht sind, **dadurch gekennzeichnet, dass** es auf der Rückseite seines Gehäuses (1) eine Leistungskarte (C1) aufweist, welche mit den Stromsensoren (I1, I2, I3) verbunden ist und über Steckverbindungen an einsteckbare elektronische Karte (C2, C3, C4) angeschlossen ist, welche seitliche, in die seitlichen Öffnungen des Gehäuses mündende Anschlussblöcke (B1 und B2) tragen, und auf der Vorderseite des Gehäuses eine Austausch- und Kommunikationskarte (C5) aufweist, welche mit mindestens einer der einsteckbaren Karten (C3) verbunden werden kann.

2. Elektronisches Relais nach Anspruch 1, **dadurch gekennzeichnet, dass** die einsteckbaren Karten (C2, C3, C4) im Gehäuse senkrecht zu der Leistungskarte (C1) eingebaut sind, wobei die Austausch- und Kommunikationskarte (C5) senkrecht zu den einsteckbaren Karten (C2, C3, C4) angebracht ist und mit der in der Mitte angeordneten Karte verbunden werden kann.

3. Elektronisches Relais nach einem der vorangehenden Ansprüche, **dadurch gekennzeichnet, dass** das Gehäuse (1) aus einem hinteren Sockel (11), welcher auf einem Untersatz befestigt werden kann, einem Kasten (12), welcher auf dem Sockel (11) angebracht ist, und einem vorderseitigen Deckel (13) besteht.

4. Elektronisches Relais nach einem der vorangehenden Ansprüche, **dadurch gekennzeichnet, dass** die erste einsteckbare Karte (C2), welche seitlich angebracht ist und mit einem Anschlussblock (B1) ausgestattet ist, eine Karte für logische Eingaben ist.

5. Elektronisches Relais nach einem der vorangehenden Ansprüche, **dadurch gekennzeichnet, dass** die zweite einsteckbare Karte (C4), welche seitlich angebracht ist und mit einem Anschlussblock (B2) ausgestattet ist, eine Ausgangskarte ist.

6. Elektronisches Relais nach einem der vorangehenden Ansprüche, **dadurch gekennzeichnet, dass** die einsteckbare Karte (C3), welche zwischen den beiden anderen Karten (C2, C4) angebracht ist, die mit einem Mikrokontroller ausgestattete Verarbeitungskarte ist.

7. Elektronisches Relais nach einem der vorangehenden Ansprüche, **dadurch gekennzeichnet, dass** die auf der Vorderseite angebrachte Austausch- und Kommunikationskarte (C5) über eine ausziehbare Steckverbindung (B3) mit der Verarbeitungskarte (C3) verbunden ist und einen Kommunikations-Steckverbinder (51) mit einem Bus oder einem Computer aufweist.

## Claims

1. An electronic relay including current sensors (I1, I2, I3) mounted, between terminals (L1, T1, L2, T2, L3, T3), in series on alternating current supply lines to a load (M) , **characterised by** the fact that it includes, at the rear of its case (1) a power card (C1) linked to the current sensors (I1, I2, I3) and connected by connectors to daughter cards (C2, C3, C4) carrying lateral terminal blocks (B1 and B2) with outputs in the lateral openings of the case and, at the front of the case, a communication and dialogue card (C5) connected to at least one of the daughter cards (C3).

2. An electronic relay according to any one of the preceding claims, **characterised by** the fact that the daughter cards (C2, C3, C4) are mounted in the case perpendicular to the power card (C1), the dialogue and communication card (C5) being mounted perpendicular to the daughter cards (C2, C3, C4) and being connected to the card positioned in the centre (C3).

3. An electronic relay according to any one of the preceding claims, **characterised by** the fact that the case (1) comprises a rear mounting base (11) capable of being fixed to a support, a box (12) which can be assembled on the mounting base (11) and a front cover (13).

4. An electronic relay according to any one of the preceding claims, **characterised by** the fact that the first daughter card (C2) mounted laterally and fitted with a terminal block (B1) is a logic input card.

5. An electronic relay according to any one of the preceding claims, **characterised by** the fact that the second daughter card (C4) mounted laterally and fitted with a terminal block (B2) is an output card.

6. An electronic relay according to any one of the preceding claims, **characterised by** the fact that the daughter card (C3) mounted between the other two cards (C2, C4) is the processing card fitted with a microcontroller.

7. An electronic relay according to any one of the preceding claims, **characterised by** the fact that the dialogue and communication card (C5) positioned at the front is connected by a removable pin connector (B3) to the processing card (C3) and has a communication connector (51) for a bus or a computer.
